# EUROPEAN PATENT SPECIFICATION

(11) **EP 1 657 753 B1**
(45) Date of publication and mention of the grant of the patent: **22.06.2011**
(21) Application number: 05256675.9
(22) Date of filing: 27.10.2005
(51) Int. Cl.: H01L 27/10

(54) **Nonvolatile memory device including one resistor and one diode**
Nichtflüchtiges Speicherbauelement mit einem Widerstand und einer Diode
Dispositif de mémoire non volatile avec une résistance et une diode

(30) Priority: 10.11.2004 KR 2004091497
(43) Date of publication of application: 17.05.2006
(73) Proprietor: Samsung Electronics Co., Ltd., Suwon-si, Gyeonggi-do (KR)
(72) Inventor: Ahn, Seung-eon, Seongbuk-gu Seoul (KR); Yoo, In-kyeong, Suwon-si Gyeonggi-do (KR); Joung, Yong-soo, Gangnam-gu Seoul (KR); Cha, Young-kwan, c/o Samsung Advanced Institute, Yongin-si Gyeonggi-do (KR); Lee, Myoung-jae, Suwon-si Gyeonggi-do (KR); Seo, David, c/o Samsung Advanced Institute, Yongin-si Gyeonggi-do (KR); Seo, Sun-ae, Taean-eub Hwaseong-si Gyeonggi-do (KR)
(74) Representative: Ertl, Nicholas Justin

(56) References cited:
- EP-A- 0 666 593
- EP-A- 1 484 799
- WO-A-00/63981
- WO-A-02/095832
- US-A- 3 705 419
- US-A- 3 796 926
- US-A1- 2003 189 851
- US-A1- 2004 159 835

## Description

### BACKGROUND OF THE INVENTION

The present invention relates to a nonvolatile memory device including one resistor and one diode.

In recent years, a lot of studies have been made of a semiconductor memory device that increases the number of memory cells per area (i.e., integration density) and operating speed and can be driven with low power, and various kinds of memory devices have been developed.

In general, a semiconductor memory device includes many memory cells that are connected through circuits. In a dynamic random access memory (DRAM) that is a representative semiconductor memory device, a unit memory cell is typically comprised of one switch and one capacitor. Such a DRAM is advantageous for high integration density and fast operating speed. However, when power supply is cut off, the DRAM loses all stored data.

By comparison, some nonvolatile memory devices, such as a flash memory device, can retain stored data even if power supply is abruptly interrupted. The flash memory device has a nonvolatile characteristic but has lower integration density and slower operating speed than a volatile memory device.

Nowadays, such nonvolatile memory devices as a magnetic random access memory (MRAM), a ferroelectric random access memory (FRAM), and a phase-change random access memory (PRAM) are laboriously under study.

The MRAM stores data using a change of magnetization direction in a tunnel junction, and the FRAM stores data using a polarization direction of a ferroelectric material. Although the MRAM and FRAM have individual merits and demerits, they basically have high integration density and fast operating speed and can be driven with low power as described above. Also, research is being carried out in a good data retention characteristic of the MRAM and FRAM.

Further, the PRAM is a memory that stores data using a certain material's characteristic, namely, a variation in resistance with respect to a phase change, and includes one resistor and one switch (transistor). The resistor used for the PRAM is a calcogenide resistor, which becomes crystalline or amorphous according to temperature that is controlled when the resistor is formed. The PRAM is formed on the principle that a crystalline resistor is typically more resistive than an amorphous resistor. In fabricating the PRAM using a conventional DRAM process, performing an etch process becomes complicated and takes much time. Accordingly, the productivity of memory devices decreases and the cost of production increases, thus weakening the competitiveness of the devices.

EP 0666 593 discloses the combination of a diode and a resistor for a memory device in which a writing operation involves providing breakdown of a resistance layer, for once-only writing. US 3 705 419 discloses the combination of a FET and a diode for a memory cell.

EP 1484799 has a publication date after the filing date of this application. It discloses a non volatile memory device comprising a switching device and a resistant material.

### SUMMARY OF THE INVENTION

According to an aspect of the present invention, there is provided a nonvolatile memory device as claimed in claim 1.

The invention provides a nonvolatile memory device including one resistor and one diode, which is fabricated in a simple process, can be driven with low power, and has fast operating speed.

The resistor structure may include a buffer layer disposed on the lower electrode; and a data storage layer disposed on the buffer layer.

The resistor structure may be formed of at least one of NiO, TiO₂, HfO, ZrO, ZnO, WO₃, CoO, and Nb₂O₅.

The diode structure may include a first oxide layer disposed on the resistor structure; and a second oxide layer disposed on the first oxide layer. Also, the first oxide layer may be formed of p-type oxide, and the second oxide layer may be formed of n-type oxide.

According to another aspect of the present invention, there is provided an array of a nonvolatile memory device as claimed in claim 7.

### BRIEF DESCRIPTION OF THE DRAWINGS

The above and other features and advantages of the present invention will become more apparent by describing in detail exemplary embodiments thereof with reference to the attached drawings in which:
FIG. 1A illustrates a nonvolatile memory device including one resistor and one diode according to an exemplary embodiment of the present invention;
FIG. 1B is a graph showing characteristics of materials used for the nonvolatile memory device including one resistor and one diode as shown in FIG. 1;
FIG. 2 illustrates an array structure of the nonvolatile memory device including one resistor and one diode as shown in FIG. 1;
FIG. 3 is an equivalent circuit diagram of the array of the nonvolatile memory device including one resistor and one diode as shown in FIG. 2;
FIG. 4 is a graph showing operating characteristics of the nonvolatile memory device including one resistor and one diode as shown in FIG. 1; and
FIG. 5 is a diagram for explaining the operating principle of the nonvolatile memory device including one resistor and one diode as shown in FIGS. 2 and 3.

### DETAILED DESCRIPTION OF THE INVENTION

A nonvolatile memory device including one resistor and one diode according to the present invention will now be described more fully hereinafter with reference to the accompanying drawings, in which exemplary embodiments of the invention are shown.

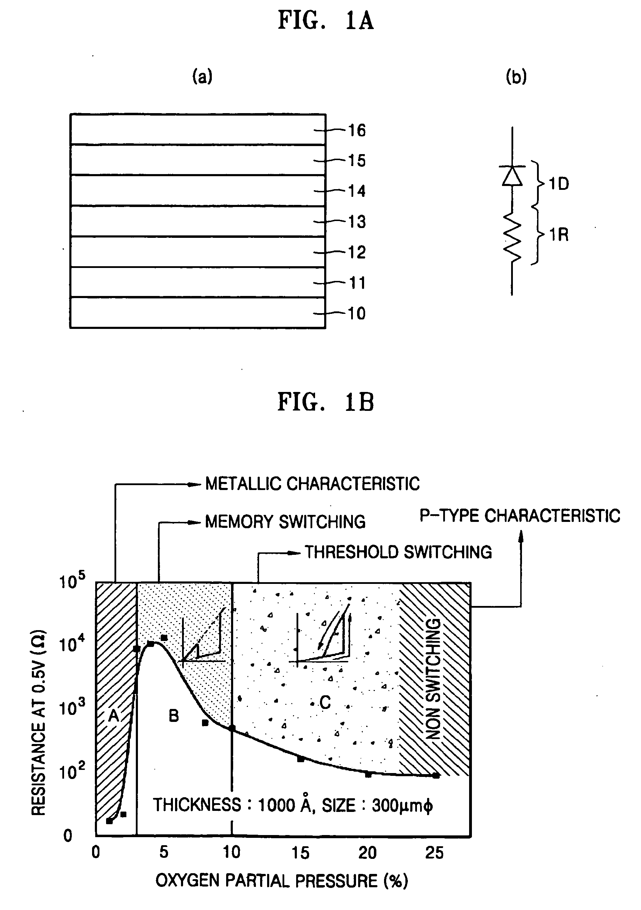

FIG. 1A is a cross sectional view of a nonvolatile memory device including one resistor and one diode according to an exemplary embodiment of the present invention.

Referring to FIG. 1A, the memory device includes a substrate 10, a lower electrode 11, resistance layers 12 and 13, a diode structure 14 and 15, and an upper electrode 16, which are sequentially stacked. Here, the resistance layers 12 and 13 function as a data storage portion. A first resistance layer 12 acts as a buffer layer, and a second resistance layer 13 acts as a data storage layer. The first resistance layer 12, which acts as the buffer layer, may be optionally formed. The diode structure 14 and 15 is a p-n junction structure and includes a first oxide layer 14 and a second oxide layer 15.

In this case, the substrate 10 may be a semiconductor substrate, such as a Si substrate, that is used for a typical semiconductor device. The lower and upper electrodes 11 and 16 may be formed of a conductive material, such as a metal, that is typically used for an electrode of a semiconductor device. In particular, a material for the lower electrode 11 may be selectively determined according to the kind of material formed thereon. The first and second resistance layers 12 and 13 are formed on the lower electrode 11. The first and second resistance layers 12 and 13 may be formed of transition metal oxide, for example, at least one of NiO, TiO₂, HfO, ZrO, ZnO, WO₃, CoO, and Nb₂O₅. The first and second resistance layers 12 and 13 may be formed of the same material, for example, NiO.

The first oxide layer 14 may be formed of p-type oxide, and the second oxide layer 15 may be formed of n-type oxide. For example, the first and second oxide layers 14 and 15 may be formed of transparent metal oxide with a controlled fraction of oxygen. The transition metal oxide has an electrical characteristic, which varies with the amount of oxygen combined with transition metal. The first and second oxide layers 14 and 15 may be formed of the same material as the second resistance layer 13, but they may exhibit a p-type semiconductor characteristic or an n-type semiconductor characteristic by increasing a fraction of oxygen more than the second resistance layer 13. Hereinafter, the first oxide layer 14 and the second oxide layer 15 will be referred to a p-type oxide layer 14 and an n-type oxide layer 15, respectively.

FIG. 1B is a graph showing characteristics of materials used for the nonvolatile memory device including one resistor and one diode as shown in FIG. 1. Specifically, FIG. 1B shows a variation in resistance with respect to a fraction oxgen partial pressure for formation of NiOₓ.

Referring to FIG. 1B, when a fraction of oxygen in NiOₓ is extremely low (region "A"), NiOₓ is similar in characteristics to Ni. However, as the fraction of oxygen gradually increases (region "B"), resistance greatly increases, thus showing a switching characteristic. As the fraction of oxygen further increases (region "C"), resistance gradually decreases, thus showing a semiconductor characteristic. Any one of the resistance layers 12 and 13, the p-type oxide layer 14, and the n-type oxide layer 15 may be formed of transition metal oxide, such as NiOₓ, with a controlled fraction of oxygen. In a manufacturing process, the resistance layers 12 and 13, the p-type oxide layer 14, and the n-type oxide layer 15 may be sequentially formed in-situ by depositing the same transition metal on a sample using sputtering while appropriately controlling the amount of oxygen gas injected into a reaction chamber. Of course, it is obvious that the above-described transition metal oxides other than NiO and a combination thereof can exhibit similar characteristics.

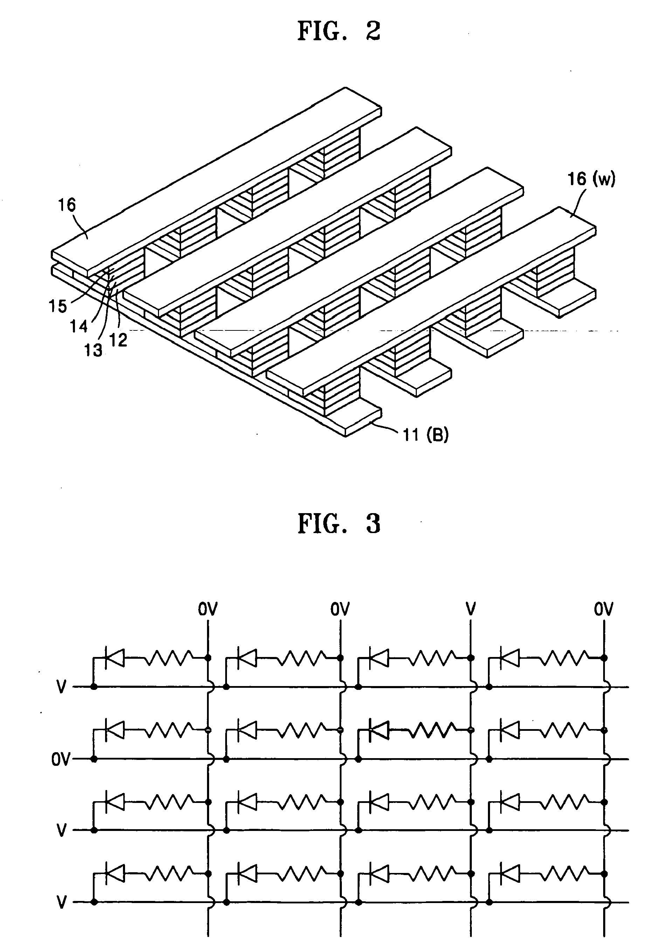

FIG. 2 illustrates an array structure of the nonvolatile memory array including one resistor and one diode as shown in FIG. 1.

Referring to FIG. 2, a plurality of lower electrodes 11 are disposed at regular intervals, and a plurality of upper electrodes 16 are disposed across the lower electrodes 11. Also, resistance layers 12 and 13 and a p-n junction diode structure 14 and 15 are formed at each of the intersections of the lower electrodes 11 and the upper electrodes 16.

FIG. 3 is an equivalent circuit diagram of the array of the nonvolatile memory device including one resistor and one diode as shown in FIG. 2.

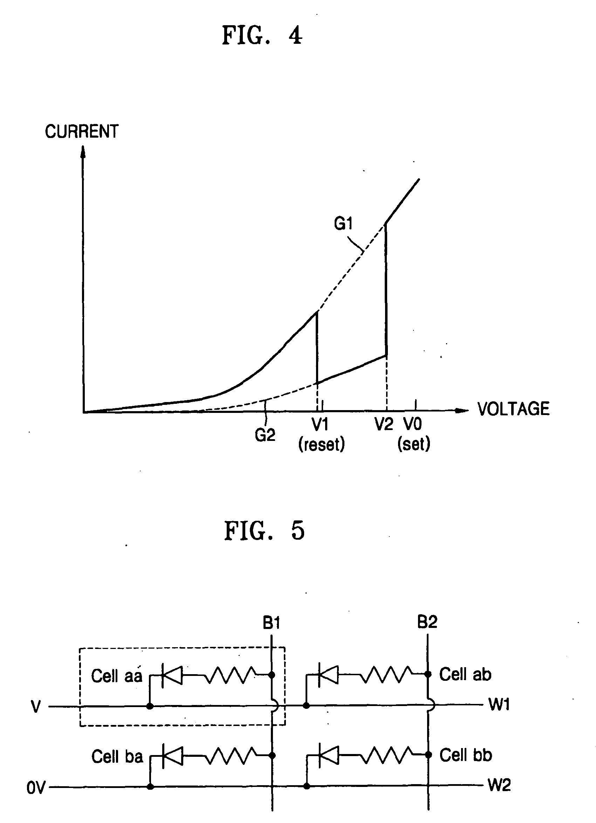

Hereinafter, the electrical characteristics of the second resistance layer 13 of the nonvolatile memory device including one resistor and one diode according to the exemplary embodiment of the present invention will be described with reference to FIG. 4. In FIG. 4, a horizontal axis refers to voltage applied through the upper and lower electrodes 16 and 11, and a vertical axis refers to current that passes through the second resistance layer 13.

FIG. 4 shows two current-voltage curves G1 and G2. The curve G1 shows a case where the resistance of the second resistance layer 13 is lowered, that is, current that passes through the second resistance layer 13 is higher for the same voltage. By comparison, the curve G2 shows a case where the resistance of the second resistance layer 13 is elevated, that is, current that passes through the second resistance layer 13 is lower for the same voltage. In the present invention, the semiconductor memory device including one resistor and one diode makes use of different current-resistance characteristics, as will now be described in detail.

At the outset, when applied voltage is gradually increased from 0V to 1V, current increases in proportion to the voltage along the curve G1. However, with the application of V1, current is suddenly reduced and varied along the curve G2. This phenomenon is continued also in the range of V1≤ V ≤ V2. Also, when voltage is applied in the range of V2 < V, current increases along the curve G1 again. Here, resistance in the curve G1 is referred to as a first resistance, and resistance in the curve G2 is referred to as a second resistance. That is, it can be seen that the resistance of the second resistance layer 13 sharply increases in the range of V1 ≤ V ≤ V2.

Also, the present inventor confirmed that the nonvolatile memory device including one resistor and one diode according to the present invention had the following characteristics. Initially, after voltage is applied in the range of V1 ≤ V ≤ V2, when voltage is applied in the range of V < V1, current is detected based on the curve G2. After voltage is applied in the range of V2 < V, when voltage is applied in the range of V < V1, current is detected based on the curve G1. Accordingly, the nonvolatile memory device can properly operate using the above-described characteristics.

That is, in the nonvolatile memory device including one resistor and one diode according to the exemplary embodiment of the present invention, when voltage is applied in the range of V2 < V through the lower and upper electrodes 11 and 16, the first resistance is stored in the second resistance layer 13. Also, when voltage is applied in the range of V1 ≤ V ≤ V2, the second resistance is stored in the second resistance layer 13. By applying a voltage less than V1 and reading a current value, a state of memory stored in the second resistance layer 13 can be read.

FIG. 5 is a diagram for explaining the operating principle of the nonvolatile memory device including one resistor and one diode as shown in FIGS. 2 and 3. FIG. 5 illustrates four memory cells 'aa', 'ab', 'ba', and 'bb', and each of bit lines B1 and B2 and word lines W1 and W2 is shared by a pair of cells.

A process of storing the first resistance (of the curve G1 of FIG. 4) in the second resistance layer 13 is referred to as a program process (set), and a process of storing the second resistance (of the curve G2 of FIG. 4) in the second resistance layer 13 is referred to as an erase process (reset).

In order to store the first resistance in the cell 'aa' of FIG. 5, a voltage of V2 or higher should be applied. For this operation, a voltage of V0 (V2< V0) is applied to the bit line B1 and the word line W2. In this case, the cells 'ab' and 'ba' do not operate because there is no difference in electric potential between upper and lower electrodes. Also, the cell 'bb' does not operate because a reverse voltage is applied thereto. Therefore, the first resistance is stored only in the cell 'aa'.

Thereafter, in order to store the second resistance in the cell 'aa', a voltage of V1≤ V ≤ V2 should be applied. For this operation, a voltage of V1≤ V ≤ V2 is applied only to the bit line B1 and the word line W2, and the bit line B2 and the word line W1 are grounded. Accordingly, the first resistance is erased from the second resistance layer 13 of the cell 'aa' and the second resistance is programmed in the second resistance layer 13. The first resistance may be designated as '0' and the second resistance may be designated as '1,' and the reverse designation is also possible.

Further, a resistance state of the second resistance layer 13 that is a data storage layer of the cell 'aa' can be read using a current value that is measured by applying a voltage Vr less than V1 to the cell 'aa'. In this case, the voltage Vr is applied only to the bit line B1 and the word line W2 as described above, it is determined whether the measured current corresponds to the curve G1 or the curve G2 of FIG. 4, and stored data is read.

The present invention has the following advantages.

First, a unit cell structure of a nonvolatile memory device includes one diode and one resistor, which are sequentially stacked. Thus, the nonvolatile memory device and an array cell structure thereof are structurally very simple.

Second, the nonvolatile memory device of the present invention can be formed using conventional DRAM manufacturing processes. Unlike a memory device including a typical switching device, a resistance layer and a diode structure formed thereon can be formed in-situ by controlling a fraction of oxygen. As a result, the manufacture of the nonvolatile memory device is very simple, so that productivity is elevated and the cost of production is lowered.

Third, considering the operating principle of the present invention, data can be stored and reproduced in a simple method using materials with unique characteristics, thus enabling high-speed operation of the device.

## Claims

1. A nonvolatile memory device including one resistor (12,13) and one diode (14,15) comprising:
a lower electrode (11);
a resistor structure (12,13) disposed on the lower electrode;
a diode structure (14,15) disposed on the resistor structure; and
an upper electrode (16) disposed on the diode structure,
**characterised in that** the resistor structure comprises a data storage resistance layer (13) formed of a transition metal oxide having an electrical characteristic, determined by the amount of oxygen combined with the transition metal, which displays a switching characteristic such that as the voltage is increased, a step change in resistance from a first lower resistance to a second higher resistance is experienced at a first voltage level (V1), and a step change from the second resistance back to the first resistance is experienced at a second voltage level (V2).

2. The device according to claim 1, wherein the resistor structure includes:
a buffer layer (12) disposed on the lower electrode; and
the data storage layer (13) disposed on the buffer layer.

3. The device according to claim 1 or 2, wherein the resistor structure is formed of at least one selected from the group consisting of NiO, TiO₂, HfO, ZrO, ZnO, WO₃, CoO, and Nb₂O₅.

4. The device according to any preceding claim, wherein the diode structure includes:
a first oxide layer (14) disposed on the resistor structure; and
a second oxide layer (15) disposed on the first oxide layer.

5. The device according to claim 4, wherein the first oxide layer (14) is formed of p-type oxide, and the second oxide layer (15) is formed of n-type oxide.

6. The device according to claim 5, wherein any one of the p-type oxide and n-type oxide is formed of at least one selected from the group consisting of NiO, TiO₂, HfO, ZrO, ZnO, WO₃, CoO, and Nb₂O₅.

7. An array of a nonvolatile memory device including one resistor and one diode, the array comprising:
at least two bit lines (B1,B2) arranged at regular intervals;
at least two word lines (W1,W2) arranged at regular intervals and disposed across the bit lines;
a resistor structure (12,13) disposed on the bit lines at each of the intersections of the bit lines and word lines; and
a diode structure (14,15) disposed in contact with the resistor structure and the word lines.
**characterised in that** the resistor structure comprises a data storage resistance layer (13) formed of a transition metal oxide having an electrical characteristic, determined by the amount of oxygen combined with the transition metal, which displays a switching characteristic such that as the voltage is increased, a step change in resistance from a first lower resistance to a second higher resistance is experienced at a first voltage level (V1), and a step change from the second resistance back to the first resistance is experienced at a second voltage level (V2).

8. The array according to claim 7, wherein the resistor structure includes:
a buffer layer (12) disposed on the lower electrode; and
the data storage layer (13) disposed on the buffer layer.

9. The array according to claim 7 or 8, wherein the resistor structure (12,13) is formed of at least one selected from the group consisting of NiO, TiO₂, HfO, ZrO, ZnO, WO₃, CoO, and Nb₂O₅.

10. The array according to claim 7, 8 or 9, wherein the diode structure includes:
a first oxide layer (14) disposed on the resistor structure; and
a second oxide layer (15) disposed on the first oxide layer.

11. The array according to claim 10, wherein the first oxide layer (14) is formed of p-type oxide, and the second oxide layer (15) is formed of n-type oxide.

12. The array according to claim 10, wherein any one of the p-type oxide and n-type oxide is formed of at least one selected from the group consisting of NiO, TiO₂, HfO, ZrO, ZnO, WO₃, CoO, and Nb₂O₅.

## Patentansprüche

1. Nichtflüchtiges Speicherbauelement mit einem Widerstand (12, 13) und einer Diode (14, 15), umfassend:
eine untere Elektrode (11),
eine Widerstandsstruktur (12, 13), die auf der unteren Elektrode angeordnet ist,
eine Diodenstruktur (14, 15), die auf der Widerstandsstruktur angeordnet ist, und
eine obere Elektrode (16), die auf der Diodenstruktur angeordnet ist,
**dadurch gekennzeichnet, dass** die Widerstandsstruktur eine Datenspeicherwiderstandsschicht (13) umfasst, die aus einem Übergangsmetalloxid mit einer elektrischen Charakteristik gebildet ist, die bestimmt ist durch die Menge an mit dem Übergangsmetall kombiniertem Sauerstoff, die eine Umschaltcharakteristik zeigt, derart, dass mit steigender Spannung eine sprunghafte Änderung im Widerstand von einem ersten niedrigen Widerstand zu einem zweiten höheren Widerstand bei einem ersten Spannungspegel (V1) auftritt und eine sprunghafte Änderung vom zweiten Widerstand zurück zum ersten Widerstand bei einem zweiten Spannungspegel (V2) auftritt.

2. Bauelement nach Anspruch 1, wobei die Widerstandsstruktur umfasst:
eine Pufferschicht (12), die auf der unteren Elektrode angeordnet ist, und
die Datenspeicherschicht (13), die auf der Pufferschicht angeordnet ist.

3. Bauelement nach Anspruch 1 oder 2, wobei die Widerstandsstruktur aus mindestens einem ausgewählt aus der Gruppe bestehend aus NiO, TiO₂, HfO, ZrO, ZnO, WO₃, CoO und Nb₂O₅ gebildet ist.

4. Bauelement nach einem der vorhergehenden Ansprüche, wobei die Diodenstruktur umfasst,:
eine erste Oxidschicht (14), die auf der Widerstandsstruktur angeordnet ist, und
eine zweite Oxidschicht (15), die auf der ersten Oxidschicht angeordnet ist.

5. Bauelement nach Anspruch 4, wobei die erste Oxidschicht (14) aus einem Oxid vom p-Typ gebildet ist und die zweite Oxidschicht (15) aus einem Oxid vom n-Typ gebildet ist.

6. Bauelement nach Anspruch 5, wobei das Oxid vom p-Typ oder das Oxid vom n-Typ aus mindestens einem ausgewählt aus der Gruppe bestehend aus NiO, TiO₂, Info, ZrO, ZnO, WO₃, CoO und Nu₂O₅ gebildet ist.

7. Array eines nichtflüchtigen Speicherbauelements mit einem Widerstand und einer Diode, wobei das Array umfasst:
mindestens zwei Bitleitungen (B1, B2), die in regelmäßigen Intervallen angeordnet sind,
mindestens zwei Wortleitungen (W1, W2), die in regelmäßigen Intervallen und kreuzweise über den Bitleitungen angeordnet sind,
eine Widerstandsstruktur (12, 13), die auf den Bitleitungen an jedem der Kreuzungspunkte der Bitleitungen und Wortleitungen angeordnet ist, und
eine Diodenstruktur (14, 15), die in Kontakt mit der Widerstandsstruktur und den Wortleitungen angeordnet ist,
**dadurch gekennzeichnet, dass** die Widerstandsstruktur eine Datenspeicherwiderstandsschicht (13) umfasst, die aus einem Übergangsmetalloxid mit einer elektrischen Charakteristik gebildet ist, die bestimmt ist durch die Menge an mit dem Übergangsmetall kombiniertem Sauerstoff, die eine Umschaltcharakteristik zeigt, derart, dass mit steigender Spannung eine sprunghafte Änderung im Widerstand von einem ersten niedrigen Widerstand zu einem zweiten höheren Widerstand bei einem ersten Spannungspegel (V1) auftritt und eine sprunghafte Änderung vom zweiten Widerstand zurück zum ersten Widerstand bei einem zweiten Spannungspegel (V2) auftritt.

8. Array nach Anspruch 7, wobei die Widerstandsstruktur umfasst:
eine Pufferschicht (12), die auf der unteren Elektrode angeordnet ist, und
die Datenspeicherschicht (13), die auf der Pufferschicht angeordnet ist.

9. Array nach Anspruch 7 oder 8, wobei die Widerstandsstruktur (12, 13) aus mindestens einem ausgewählt aus der Gruppe bestehend aus NiO, TiO₂, HfO, ZrO, ZnO, WO₃, CoO und Nb₂O₅ gebildet ist.

10. Array nach Anspruch 7, 8 oder 9, wobei die Diodenstruktur umfasst:
eine erste Oxidschicht (14), die auf der Widerstandsstruktur angeordnet ist, und
eine zweite Oxidschicht (15), die auf der ersten Oxidschicht angeordnet ist.

11. Array nach Anspruch 10, wobei die erste Oxidschicht (14) aus einem Oxid vom p-Typ gebildet ist und die zweite Oxidschicht (15) aus einem Oxid vom n-Typ gebildet ist.

12. Array nach Anspruch 10, wobei das Oxid vom p-Typ oder das Oxid vom n-Typ aus mindestens einem ausgewählt aus der Gruppe bestehend aus NiO, TiO₂, Info, ZrO, WO₃, CoO und Nb₂O₅ gebildet ist.

## Revendications

1. Dispositif de mémoire non volatile incluant une résistance (12, 13) et une diode (14, 15) comprenant :
une électrode inférieure (11) ;
une structure de résistance (12, 13) disposée sur l'électrode inférieure ;
une structure de diode (14, 15) disposée sur la structure de résistance ; et
une électrode supérieure (16) disposée sur la structure de diode,
**caractérisé en ce que** la structure de résistance comprend une couche de résistance de stockage de données (13) formée d'un oxyde de métal de transition ayant une caractéristique électrique, déterminée par la quantité d'oxygène combinée avec le métal de transition, qui présente une caractéristique de commutation telle que lorsque la tension est augmentée, un changement par palier de résistance d'une première résistance inférieure à une seconde résistance supérieure se produit à un premier niveau de tension (V1), et un changement par palier de la seconde résistance de retour à la première résistance se produit à un second niveau de tension (V2).

2. Dispositif selon la revendication 1, dans lequel la structure de résistance inclut :
une couche tampon (12) disposée sur l'électrode inférieure ; et
la couche de stockage de données (13) disposée sur la couche tampon.

3. Dispositif selon la revendication 1 ou 2, dans lequel la structure de résistance est formée d'au moins un élément choisi dans le groupe consistant en NiO, TiO₂, HfO, ZrO, ZnO, WO₃, CoO et Nb₂O₅.

4. Dispositif selon l'une quelconque des revendications précédente, dans lequel la structure de diode inclut :
une première couche d'oxyde (14) disposée sur la structure de résistance ; et
une seconde couche d'oxyde (15) disposée sur la première couche d'oxyde.

5. Dispositif selon la revendication 4, dans lequel la première couche d'oxyde (14) est formée d'un oxyde de type p, et la seconde couche d'oxyde (15) est formée d'un oxyde de type n.

6. Dispositif selon la revendication 5, dans lequel l'un quelconque de l'oxyde de type p et de l'oxyde de type n est formé d'au moins un élément choisi dans le groupe consistant en NiO, TiO₂, HfO, ZrO, ZnO, WO₃, CoO et Nb₂O₅.

7. Réseau d'un dispositif de mémoire non volatile incluant une résistance et une diode, le réseau comprenant :
au moins deux lignes de bits (B1, B2) agencées à intervalles réguliers ;
au moins deux lignes de mots (W1, W2) agencées à intervalles réguliers et disposées à travers les lignes de bits ;
une structure de résistance (12, 13) disposée sur les lignes de bits à chacune des intersections des lignes de bits et des lignes de mots ; et
une structure de diode (14, 15) disposée en contact avec la structure de résistance et les lignes de mots ;
**caractérisé en ce que** la structure de résistance comprend une couche de résistance de stockage de données (13) formée d'un oxyde de métal de transition ayant une caractéristique électrique, déterminée par la quantité d'oxygène combinée avec le métal de transition, qui présente une caractéristique de commutation telle que lorsque la tension est augmentée, un changement par palier de résistance d'une première résistance inférieure à une seconde résistance supérieure se produit à un premier niveau de tension (V1), et un changement par palier de la seconde résistance de retour à la première résistance se produit à un second niveau de tension (V2).

8. Réseau selon la revendication 7, dans lequel la structure de résistance inclut :
une couche tampon (12) disposée sur l'électrode inférieure ; et
la couche de stockage de données (13) disposée sur la couche tampon.

9. Réseau selon la revendication 7 ou 8, dans lequel la structure de résistance (12, 13) est formée d'au moins un élément choisi dans le groupe consistant en NiO, TiO₂, HfO, ZrO, ZnO, WO₃, CoO et Nb₂O₅.

10. Réseau selon la revendication 7, 8 ou 9, dans lequel la structure de diode inclut ;
une première couche d'oxyde (14) disposée sur la structure de résistance ; et
une seconde couche d'oxyde (15) disposée sur la première couche d'oxyde.

11. Réseau selon la revendication 10, dans lequel la première couche d'oxyde (14) est formée d'un oxyde de type p, et la seconde couche d'oxyde (15) est formée d'un oxyde de type n.

12. Réseau selon la revendication 10, dans lequel l'un quelconque de l'oxyde de type p et de l'oxyde de type n est formé d'au moins un élément choisi dans le groupe consistant en NiO, TiO₂, HfO, ZrO, ZnO, WO₃, CoO et Nb₂O₅.
